(19) Europäisches Patentamt / European Patent Office / Office européen des brevets

(11) **EP 3 974 852 A1**

(12) **EUROPEAN PATENT APPLICATION**
published in accordance with Art. 153(4) EPC

(43) Date of publication:
**30.03.2022   Bulletin 2022/13**

(21) Application number: **20901506.4**

(22) Date of filing: **15.12.2020**

(51) International Patent Classification (IPC):
**G01R 31/36** (2020.01)   **H01M 10/48** (2006.01)

(52) Cooperative Patent Classification (CPC):
**Y02E 60/10**

(86) International application number:
**PCT/ES2020/000058**

(87) International publication number:
**WO 2021/123468 (24.06.2021 Gazette 2021/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.12.2019   ES 201900184**

(71) Applicant: **Parres García, Luis Arturo**
**Madrid 28036 (ES)**

(72) Inventor: **Parres García, Luis Arturo**
**Madrid 28036 (ES)**

(74) Representative: **Elzaburu S.L.P.**
**Edificio Torre de Cristal**
**Paseo de la Castellana 259 C, planta 28**
**28046 Madrid (ES)**

(54) **METHOD AND SYSTEM FOR CALCULATING THE ENERGY AVAILABLE IN AN ELECTRIC BATTERY AT ANY MOMENT DURING THE LIFE THEREOF, WITHOUT DISCHARGING SAME, AND THE AUTONOMY, CAPACITY AND REMAINING LIFE THEREOF**

(57)   This method calculates the **available energy, ED,** of any battery **W,** without discharging it, at any temperature $T_n$ and at all times. A family of $G_{n,I}$ curves is generated, typical of each battery and temperature, discharging batteries of different capacities at a fixed discharge intensity, **ID.** Discharging **W** with the same **ID** produces a response voltage with which entering $G_{n,I}$, **ED** is obtained. It also provides your **capacity, autonomy,** and **remaining life.** When the battery is fully charged, **ED** is the **capacity.** Calculating **Lw,** the remaining life is found. With the **ED** and the **Balance of Consumption, autonomy** is obtained. The above is automated by connecting to a **System** that comprise; **MCU,** temperature sensor, discharger, voltmeter, ammeter, interface, etc., obtaining the **ED, capacity, autonomy,** and **remaining life.** The use of this method allows the optimization of the batteries, as well as knowing their autonomy, for example, in an **EV.**

Figure 2

# Description

## The technical field

This patent belongs to the electrical sector, to sum up more to the **electrochemical** one, and specifically to the battery field, both rechargeable and single-use. Until today, there is no reliable way of finding the **Available Energy** of a battery, from now on **ED,** without having to discharge it, except for the capacity provided by the manufacturer when new, charged, and at the standardised temperature. This method calculates it at all times in its life; that is to say, when it has aged, it has made unknown partial discharges since its last charge, and all this at any temperature.

## The state of the art

There are many devices that use electric batteries for autonomous operation. The unpredictable exhaustion of the battery can produce from discomfort to serious problems depending on the circumstances of the equipment that has it in use.

The current problem is the difficulty of knowing the **ED** of a battery when it is old, without discharging it. It is of great interest that it is not discharged, especially when the energy that the battery still accumulates is needed immediately. It is also important to know how the temperature at which the battery is or will be discharged, affects its autonomy.

The state of the **ED** a battery is affected by multiple circumstances: such as old age, previous cycling, electrochemical stress suffered, partial discharges since the last recharge and the temperatures at which they have been carried out, including that of the battery at the time of analysis, etc.

In general, everyone has the experience of mobile phone autonomy, and its accelerated loss at the end of its useful life. When the battery is new and freshly charged, the display facilitates the charge status by showing 100% and often a small green battery full in one corner. But when it is old also and freshly charged, the same information also appears, and the autonomy is much lower.

As of today the autonomy of a battery at any time in its life is not known a priori. And especially if the battery is going to be affected by an extreme temperature. This happens because the only information available comes from measuring the voltage, which is not reliable for knowing the **ED,** the capacity or the autonomy. The voltage can sometimes give an indication of the state of charge, which is of little value if the capacity is not known.

It is seldom the case that information on the minutes still available on a mobile phone is important, although this is not always the case. In general, its charging and usage temperature change little, which helps improve predictability. It helps to link the history of use, previous autonomies, expected capacity loss curve, etc. In other words, extrapolate the history, but you will completely miss the forecast if you then use it in a ski resort.

There are other applications where the lack of knowledge of autonomy can be of enormous relevance. A good example is the electric vehicle **EV,** where an error in such information can mean not being able to reach a recharging point by your own means. Or in the case of such a point being occupied or damage, knowing whether or not the next point can be reached. In the same way it is important to know the real capacity of the batteries in activities where it is also essential to have certainty of service, such as nuclear power stations, high speed trains, aeroplanes, solar installations, etc.

The following example may be illustrative. In February 2019, Chicago recorded temperatures of -30°C. This is usually about 50°C difference between the charging and operating temperature of an **EV.** The capacity loss with such a difference is of the order of 55% of the remaining capacity. This meant that many vehicles that were fully charged and had made a certain journey in the previous days were unable to do so, and were left standing on many roads without power. This is the importance of knowing how temperature affects.

In many cases, this lack of knowledge means that the batteries are now being replaced prematurely because of doubts about the real remaining capacity. Correct information on such a parameter means great savings, since the battery can work to the limit of its life, without making any changes

Once the **ED** is known, and as an application, we will be able to calculate the **autonomy** that the equipment has, whether it is a mobile phone, **EV, UPS,** etc., which is a function of the consumption that is foreseen from that moment. These needs will be detailed in an **Electric Balance of Consumption,** from now on **BEC.** It is not the object of this patent to analyse the previous **Balance Sheet** nor its obtaining, which is considered to be known.

At present, there is no known process or device that provides a satisfactory response to the above problem. In other words, there is nothing that can provide a reliable solution without discharging the battery, which is a basic condition if the available charge is then needed.

Recently, electricity consumption metering devices are coming out that improve information. Some count and memorize the last consumption and then extrapolate, even accompanied by an algorithm that follows the discharge curve. But they do not take into account aspects that drastically influence battery capacity, such as temperature. Please note that charging and usage temperatures can differ greatly. However, we will explain everything we know about this.

There are different methods for calculating the state of charge, including the state of health or conservation, that is the operating situation of the battery. But they only give approximations to the problem we are posing, with great errors and without reliability. Some methods even consist of calculating average values by applying two or more of them in order to try to minimise errors. This is only of statistical interest.

As we have justified, those methods which are based on a total discharge of the battery by applying an energy meter, and which leave the battery unable to be used immediately, are completely discarded. They cannot be applied to primary batteries, nor, of course, to those that are going to change temperature. Without being exhaustive, some of the works consulted are set out below:

a) Those that measure the density of the electrolyte. The main disadvantage of the method is that most batteries are sealed, especially the primary ones, making their use impossible. In accessible batteries, the electrolyte is acid, making the method very unsuitable for the ordinary user because of its danger. It involves the measurement of all the cells that make up the battery, which in installations that have a high voltage, and therefore number of cells, means a considerable amount of time. Even so, the method is far from reliable. In any case, they are unable to make a prediction if the temperature changes. And in no case of the capacity, although they can give an idea of the state of charge, which serves for very little without knowing its capacity.

b) Peukert's Law. It is a classic method. It does not consider the temperature. This simple detail disqualifies it. It can be found explained in many places, one of the simplest is https://en.wikipedia.org/wiki/Peukert%27s law

c) Shepherd's Law. The same commentary can be made. As they are classics very well known, so we do not give more details.

d) Methods based on internal resistance. Apart from the difficulty of data collection, they also do not consider temperature. https://www.scienceabc.com/innovation/what-are-the-different-methods-to-estimate-the-state-of-charge-of-batteries.html

e) Some recent works (less than a year and a half old) can be found on the Internet where the basic methods are explained such as: https://academicae.unavarra.es/bitstream/handle/2454/21830/TFG GuembeZabalet a.pdf?sequence=1&isAllowed=y

f) There are also numerous US patents on the subject. We refer to those we understand that add more consistent aspects to our objective, but without reaching it. The next one we mention, published five months ago, collects all the updated knowledge and, in turn, refers to numerous previous patents. However, it does not consider temperature changes. We will partly rely on it. In this first link it appears as published in the USA Bulletin.
US Patent No. 10,302,709, dated 28 May 2019. Shoa Hassani Lashidani et al. https://pdfpiw.uspto.gov/.piw?PageNum=0&docid=10302709&ID-Key=526056D4F68             4&HomeUrl=htp%3A%2F%2Fpatft.usp-togov%2Fnetacgi%2Fnph-Parser%3FSect1%3DPTO2%2526Sect2%3DHITOFF%2526p%3D1%2526u%3D%25252Fnetahtml%25252FPTO%25252Fsearch-bool.html%2526r%3D1%2526f%3DG%2526l%3D50%2526co1%3DAND%2526d%3         DP-TXT%2526s1%3DCadex.AS-NM.%2526OS%3DAN%2FCadex%2526RS%3DAN %2FCadex

g) Below, we show the same patent in a more convenient format for printing and reading.
US Patent No. 10,302,709, dated 28 May 2019. By Shoa Hassani Lashidani et al.
http://patft.uspto.gov/netacgi/nph-Parser?Sect1=PTO1&Sect2=HITOFF&d=PALL&p=1&u=%2Fnetahtml%2FPTO%2Fsrch-num.htm&r=1&f=G&l=50&s1=10,302,709.PN.&OS=PN/10,302,709&RS=PN/10, 302,709

h) Item more:
US Patent No. 9,692,088 Koba et al. 27 June 2017.
http://patft.uspto.gov/netacgi/nph-Parser?Sect1=PTO1&Sect2=HITOFF&d=PALL&p=1&u=%2Fnetahtml%2FPTO%2Fsrch-num.htm&r=1&f=G&l=50&s1=9,692,088.PN.&OS=PN/9,692,088&RS=PN/9,692, 088

i) Item more:
US Patent No. 7,619,417 Klang 17 November 2009
http://patft.uspto.gov/netacgi/nph-Parser?Sect2=PTO1&Sect2=HITOFF&p=1&u=%2Fnetahtml%2FPTO%2Fsearch-bool.html&r=1&f=G&l=50&d=PALL&RefSrch=ves&Querv=PN%2F7619417
This patent, in the section "Capacity", page 12, lines 55 to 58 says literally;
***"It seems logical that it would be easy to calculate the low rate capacity of a battery, but in actually discerning this property has been and continues to be a challenge to the battery industry".***

In other words, at the time this patent was written it was not known how to find the capacity of a battery. This patent is held by Shoa Hassani, so it seems that no progress has been made to date.
In addition, none of them can predict the behaviour of the battery at any time in its life and especially when the temperature changes.

## Explanation of the method

## Glossary

Many of the terms explained here are well known, but they should be made vey specific given the many misconceptions found in many books and publications.

a) **B, W, A:** Generic name of batteries. **B** is reserved for those that are new, charged, fully formed and at rest. Those batteries that are subject to this method are called **W,** with a certain age, even new ones, at any time of their life, and at any temperature. **W** and **B** are initially the same battery, it is called **B** when it is new and **W** when it is old. **A** is used for the **equivalent batteries** which are new and charged, that is to say those type **B** which will have an **ED** identical to the remaining energy available to the battery **W** being analysed.
This patent uses as an example the sealed lead acid battery with glass wool separators, by their acronym **SLA-AGM.** Sealed lead acid absorbed glass material.

b) **BEC:** It is the *Electrical Balance of Consumption.* Note that such balance must be very complete, where not only the discharges are included, but also the charges, as for example those coming from a braking in an **EV.** And any current that may produce stress to the battery, such as extra opening and closing currents, harmonics, etc., and also the foreseeable temperatures during each charge or consumption.
This **balance** is usually variable in relation to time. Using the **EV** as an example, to obtain it you must enter the speed chosen, the driving style, the weight and load of the vehicle, and the use or not of other consumers. If more autonomy is required, the **BEC** can be changed by introducing lower requirements, in order to increase it. Some of the information can also be fixed, such as the slopes of a road to be travelled, or dynamic, and even alien to our actions, such as a variable temperature during such a journey. It is assumed that the EV has access to forecasts or telematic information. It can be equipped with an alarm if consumption or autonomy changes. It is not the object of this patent to analyse or obtain the **BEC** that is assumed to be known.

c) **Capacity.** This is the ability of a battery to transform the maximum possible **electrochemical potential** into useful electricity under certain circumstances. And, if it is rechargeable, it measures its aptitude for transforming electricity into the maximum possible **electrochemical potential.** It is measured in **Ah.**

Although what is really considered is always energy, so it is understood that the voltage is always known. Sometimes it is given as the possible watts to supply during a certain time, with a final voltage $V_f$ and at the regulated temperature. In this last case, useful energy is directly promised. The differences in the initial capacity of a battery, and the maximum capacity reached after a few cycles, as a function of the complete formation, etc., are not considered. The capacity decreases when the temperature decreases or when the discharge intensity increases.

ch) **Nominal capacity $C_N$.** This is the initial capacity of a new battery. It is defined, according to the **Standard,** as that which allows an $I_N$ discharge in a time $t_N$, at a temperature $T_N$, and with a final voltage $V_f$. Being verified: $C_N = I_N \times t_N$

d) **Minimum capacity $C_m$.** The **Standard** defines the lowest acceptable remaining capacity according to the use to which the battery is destined. $C_m$ usually varies between **0.6** and **0.8 $C_N$.**

e) **Remaining capacity $C_R$** of a battery, is the one existing at a given moment, when part of the expected life has elapsed and a certain initial capacity has been lost.

f) **C.** This is the capacity of an **equivalent battery A** that is found as a result of this method. It will be equal to or less than the $C_N$ of the battery analysed. It also has a generic meaning.

g) $C_n$. It is the capacity at temperature $T_n$ of a battery **W** that at $T_N$ had a capacity of $C_N$. At a lower temperature than $T_n$, it is lower than $C_N$. There is a curve that relates them. This curve is valid at any time during its life.

h) **Remaining charge.** Useful electrical energy is also called charge. When a discharge is partial or if the temperature changes, the charge that remains available in the battery is called **residual charge or remaining energy,** which are an approximation of **ED,** the difference being the minimum non-operational charge.

i) **Available energy, ED.** This is the maximum energy that can be obtained from a **W** battery at any time in its life, discharging it under certain conditions, until the final voltage $V_f$ is reached. All batteries, especially rechargeable batteries, have a final discharge voltage, which varies according to the intensity of discharge. In the case of rechargeable batteries, this $V_f$ is the minimum that should not be exceeded, since it represents an irreversible deterioration of the battery. On the other hand, it is usually close to the minimum operating voltage of the equipment it supplies.

In primary batteries this concept is not applicable, as the equipment simply stops working. At that point $V_f$, there is a certain minimum charge, or minimum energy, which is proportionally very small. The concept of **ED** is the total remaining energy minus that minimum energy that should not be available to avoid damaging the battery, and which is usually neglected because of its relatively very small value. It is easy to calculate. This minimum energy varies for the same battery depending on the temperature and the discharge intensity, **ID.** Given the small difference, and in a first approximation, we will accept in certain points to use indistinctly **ED, remaining charge** or **active electrochemical potential.**

**j) State of charge.** The level or amount of percentage charge remaining in the battery **W,** as opposed to the maximum capacity at that time, is called the state of charge. The capacity of a battery has no relation to the state of charge, nor to the open circuit voltage when it is charged. It is necessary to know both the capacity and the state of charge at the same time in order to know the **ED.** There is a curve that relates the state of charge to the voltage. The acronym in English is **SOC,** state of charge.

**k) EV.** This is the English acronym for electric vehicle. This is usually the name given to 100% electric vehicles. If they are mixed they are called hybrids, HEV. And if they are additionally plug-in, PHEV.

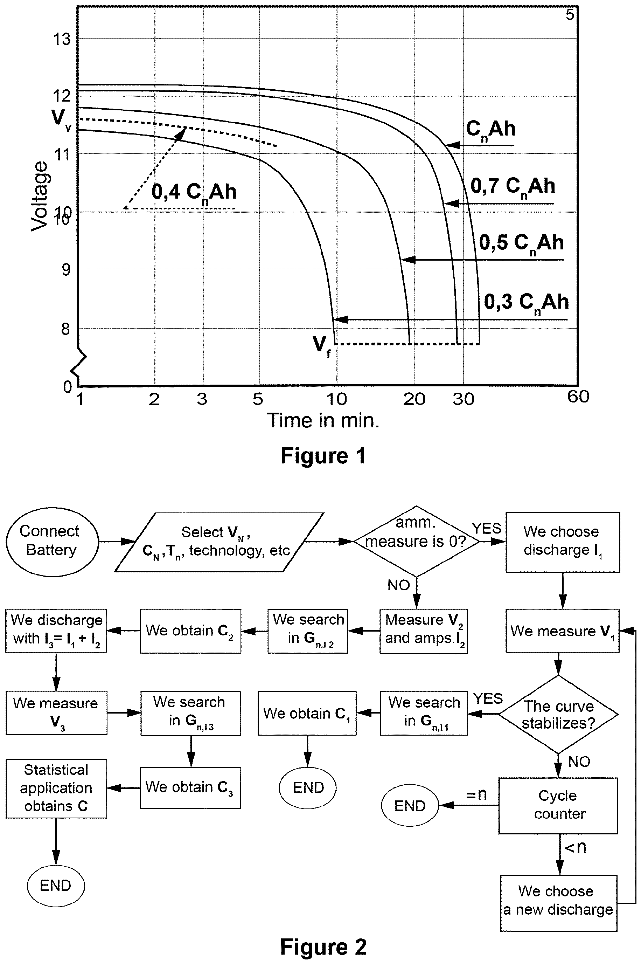

**l) $G_{n,l}$.** Given a new battery **B** with capacity $C_n$, voltage $V_N$ and temperature $T_n$, $G_{n,l}$, is the name of a family of discharge curves generated by the same fixed **ID, I,** applied to **B** and to several new and charged batteries of different capacities below **B,** all at the same temperature. The **ID** is predetermined manually or by the **System,** and usually varies between **0.1 $C_n$** and **2 $C_n$ Amp.,** and the capacity of the batteries to be discharged varies between **0.1 $C_n$** and **$C_n$ Ah.** A possible example is $G_{n,1'0}$, which is the family corresponding to the temperature $T_n$ at which battery **B** has a capacity of $C_n$. A discharge equal to **1.0 $C_n$ Amp.** is chosen for the following batteries which have, for example, capacities of **0.3 $C_n$, 0.5 $C_n$, 0.7 $C_n$,** and **$C_n$ Ah.** These curves allow their interpolation. See **Figure 1.**

**m) ID, $I_i$, $I_N$. Intensity of discharge,** and also in plural. The first two stands are generic. With the second one, it is possible to refer to a set of **generic discharge intensities $I_i$,** which by varying the sub-index, allows to represent several specific intensities. The reference standard is $I_N$. It is measured in amperes and, as a guideline, in this method varies between $I_N$ **Amp.** and **60 $I_N$ Amp.**

In **SLA** batteries, the usual discharges vary between **0.01** and **3 $C_N$ Amp.** The norm for knowing the capacity in lead is usually **0.05 $C_N$ Amp.** and **$t_N$ = 20 h.** Discharges can be down till $V_f$ voltage, so that the battery is not damaged. The curves are represented on orthogonal Cartesian coordinate axes that measure the voltage on the ordinates and the time on the abscissa on a logarithmic scale.

It should be noted that when a battery is required to be discharged at **I Amp.** what is really done is to require energy, that is, watt hours are discharged, since demand is carried out at a certain voltage and during a certain period of time.

**n) MCU.** Abbreviation of Micro Controler Unit. It comprises the **CPU** (Central Processing Unit), with one or more multicore microprocessors, memories, algorithms, software, etc.

**ñ) Standard.** Ascribed to our sector, it is the set of rules, formulations, criteria, specifications and technical standards that limit, specify, typify and define the parameters that characterise batteries. It allows to know and compare easily their performances. Among the best known technical standards are DIN, JIS, IEC, CEI, UL. While some focus on technical considerations, others do so on safety of use.

The **Standard** can be dictated by anyone, but it is highly recommended to follow the known ones. In our case, specific for each technology the working temperature, time and intensity of discharge, nominal voltage and minimum $V_f$ at different intensities of discharge, normal capacity $C_N$ and minimum $C_m$, among other things. All the measurements and curves must follow this **Standard.** Each technology and **Standard** implies different curves.

**o) p.** It is the percentage of **electrochemical potential** or **ED** of an equivalent battery **A** with capacity **C,** that has been consumed when making an incomplete discharge over the total initial **potential.** Therefore, **ED (1 - p)** is equal to the remaining **ED.**

**p) Electrochemical potential.** This is the energy resident in certain chemical substances which, when correctly activated, can provide electrical energy. The battery is a suitable container that contains a series of products with **electrochemical potential,** and is the physical medium where the reaction that transforms such **potential energy** into electricity takes place.

There is no electricity in a charged and insulated battery. Electricity will only properly exist when the **electrochemical** reaction that generates it occurs. And to trigger it, an external circuit connected to the battery is necessary. Electricity is produced by the chemical reaction that such a connection causes.

The potential energy of a charged and a discharged battery are different. The first situation is called **active electrochemical potential,** and the second **passive electrochemical potential.**

**q) UPS.** Acronym for Uninterruptible Power Supply. In Spanish SAI.

**r) System.** Name of the device that allows to automate the calculation of the method, for which it comprises a set of elements such as **MCU,** memories, microprocessors, electronic circuits, algorithm processor, voltmeter, discharger, ammeter, temperature sensor, chronometer, capacity to calculate parameters and generate curves, also including adapter, the corresponding software and hardware, interface, etc., that allows us to inform about the variables and receive the results, and even to consider information via telematics. It is also occasionally called a Battery Management System **(BMS).** Although the latter term is often used for a much simpler management of control over the charge, discharge, and limiter.

**s) SLA-AGM.** Acronym for Sealed Lead Acid and Absorbed Glass Material, which means into sealed lead acid with fiberglass separators. It is the battery technology that this patent uses as example, since is possibly the most popular, mature, and with a fairly stable evolution.

**t) SOC.** Acronym for State of Charge. Very frequently used in the sector.

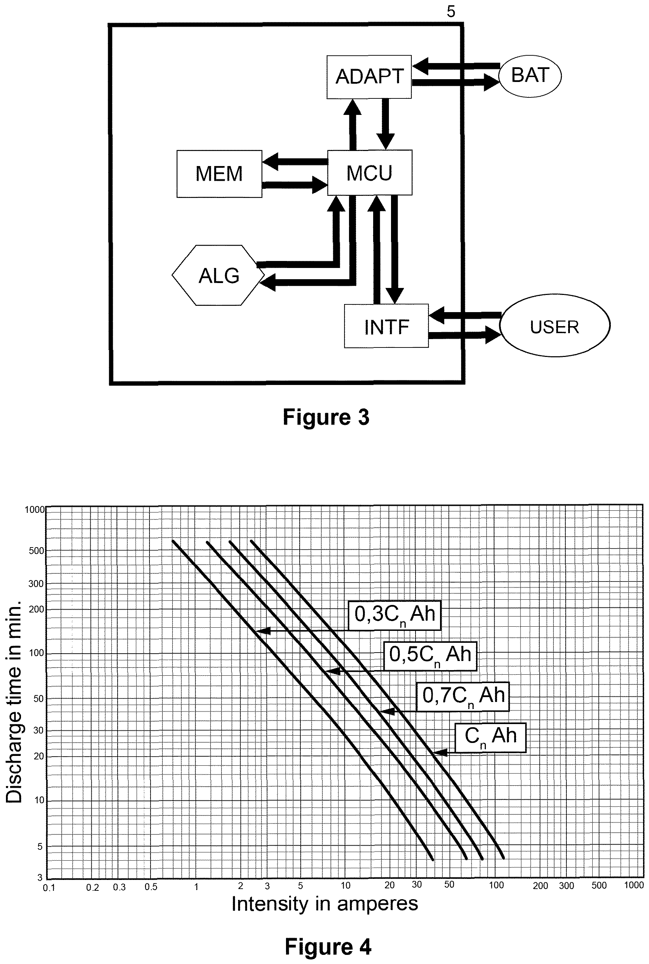

**u) $t_N$. Nominal time.** This is the time that the **Standard** sets to elapse when battery **B** is discharged at current $I_N$, at $T_N$ temperature and without the voltage dropping below $V_f$. When referring to *generic time values*, **t** is used. If $t_M$ is written, it means that it is the maximum time of autonomy of a battery with capacity **C,** at a specific **ID.** Logarithmic graphs are usually applied where the abscissa is the **ID** and the ordinate is the autonomy. See **Figure 4. $t_N$ = 20h** usually is used for lead.

**v) $T_N$.** It is the temperature that the **Standard** proposes to measure the normalized values, and particularly during the basic generation of curves. When the temperature varies, the subscript **"n"** in $T_n$ is used generically. Usually $T_n$ is between -30ºC, and 60ºC. There is a curve that relates it to the capacity.

If one **Ah** is required of a battery at different temperatures, the energy cost will be different.

**w) Nominal voltage $V_N$.** It is defined by the **electrochemical** technology of the battery construction. This voltage or tension results from the algebraic sum of the normal reduction and oxidation potentials at 25ºC of the electrodes. Thus, and as an example, it is calculated below for a lead battery. In the discharge with a 4 molal concentration of sulphuric acid, the normalised oxidation potential of the positive electrode $PbO_2$, cathode, at 25ºC, is of the order of +1.70 Volts. And for the negative electrode **Pb,** anode, the reduction potential is about -0.33 Volts. Add 2.03 Volts. The negative must be subtracted. And this is its $V_N$. It can rise or fall with the concentration of acid, hence the measurement of the density of the electrolyte in open batteries gives an idea of its state of charge, since the discharge decomposes part of the acid into water. The charge of the battery implies a reverse circulation of electricity, and the electrodes will reverse their polarity. If a secondary battery at rest has a voltage lower than $V_N$, it needs an urgent recharge.

**x) Maximum voltage $V_M$** is what the battery reaches when it is at rest and fully charged. It must always be higher than $V_N$.

**y) Intermediate voltage $V_v$.** This is a generic voltage that varies between $V_M$ and $V_f$.

**z) Final voltage $V_f$.** This is the minimum that can be reached in a discharge to avoid damage to the battery. At that end point $V_f$ there will still be a certain very small *remaining charge*. The end-voltage $V_f$ varies according to the intensity of the discharge. See more under **i).**

**Theoretical basis**

This method has its academic origin in an approach that has not evolved so far. A large part of the industry implicitly poses the problem as if the battery were a petrol tank. It is required at any time and under any condition that the same litres that has been introduced, are available. In the case of the battery, the same ampere-hours supplied. And it is not like that.

The patented method is valid for both primary and rechargeable batteries, open or sealed, and of any technology, as long as that we discount the memory effect. For secondary batteries, reversibility does not only consist of the **electrochemical process,** but also of the **mechanical process,** since the active masses must be replaced on the corresponding electrodes when the charging process regenerates them. These reactions are always exothermic, so some of the energy used will be used for heat production.

As the $G_{n,I}$ curves are the basis of this patent, their obtaining is explained below. Given a new battery **B** with a capacity $C_n$, voltage $V_N$, and at a temperature $T_n$, this is the name given to a family of discharge curves produced by the same fixed **ID I,** applied to **B** and to several new batteries of different capacities lower than **B,** always at the same temperature. The **ID** is predetermined manually or by the **System,** and usually varies between $0.1 C_n$ and $2 C_n$ **Amp.** and capacities between $0.1 C_n$ and $C_n$ **Ah.**

A possible example is $G_{n,1'0}$, which is the family corresponding to the temperature $T_n$, at which battery **B** has a capacity of $C_n$. A discharge equal to $1.0 C_n$ **Amp.** is chosen for the following batteries, which have capacities of $0.3 C_n$, $0.5 C_n$, $0.7 C_n$, and $C_n$ **Ah.** These curves allow their interpolation. See **Figure 1.**

The same discharge I is then used and applied to **W,** which returns a **Vv** response, starting a new discharge curve. With this response we look for an **equivalent battery A** in $G_{n,I}$, which allows us to find **ED.** The behavior of **A** will be identical to that of the battery **W** at that moment, so to consider any change of **ID** or $T_n$, we will use this **equivalent battery,** which will have the same response. In our example, the generated curve is the one of points, and **A** will have a capacity of **0.4 Ah.** See **Figure 1.** If $T_n$ change, changes also all the curves.

Re-evaluating the criteria for choosing **IDs,** it should be considered that the curves produced provide a clear and differentiable response. If the discharge were proportionally very small, the proximity of the response curves to each other would make it difficult to differentiate them. Neither should the discharge be too large as this would imply over-dimensioned connections and resistances for the targets.

When an **ID** is proportionally very high, the **capacity** decreases greatly because the **electrochemical** reaction does not have time to complete reaching the entire active mass, as well as the energy dedicated to producing heat. The heat that must be dissipated, supposes an irrecoverable loss of **electrochemical potential,** although the effect is small since the time is very short, between five and twenty seconds. In addition, a certain amount of stress is placed on the battery.

Pulses of any type can also be used. The situation of the battery should be considered as far as is known to be consistent with the **ID.** It is always advisable to start with the minimum operational discharges. In general they vary between $0.1 C_n$ and $2 C_n$ **Amp.** In the case of **SLA-AGM** it is possible to start between $0.6 C_n$ and $1 C_n$.

This method is applicable to any **W** battery at any time in its life. If, from previous measurements, the current capacity is known, even if it is out of date, this value should be taken as the starting point instead of the nominal capacity when it was new. However, it is still assumed that no prior information is available.

Likewise, and as utilities or applications there are the following. Once the **ED** and the **BEC** are known, the **autonomy** can be calculated at the desired temperature. Even in the case that the temperatures and discharges that occur are variable.

**Capacity** can also be calculated. After a recharge, when we notice that the charger does not supply appreciable electricity to the battery, we disconnect it and calculate **ED.** This value is the **capacity** of the battery **W** at the measurement temperature. If the battery is primary, the **ED** coincides with its **capacity** at all times.

With the curve of the evolution of the **capacity** in time, the **remaining life** $t_R$ can be calculated. It should be clarified that the correct use of the term **expected life tw,** serves to specify the maximum time of life of a new product under certain circumstances. The same concept can be used for batteries. It is more interesting to find the **remaining life** $t_R$ in our patent, that is the remaining usefull life from any moment on. It is convenient to start from the knowledge of the $L_M$ and $L_D$ curves, which are provided by the manufacturer and can be standardised.

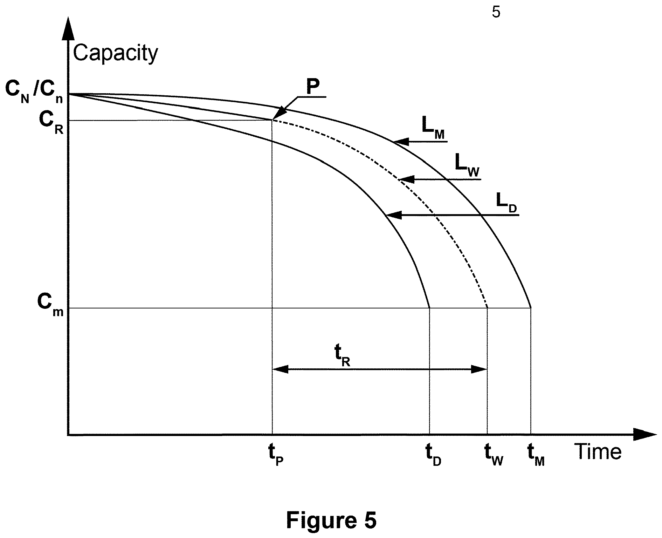

To calculate these curves, orthogonal Cartesian axes are used, in which time is measured in the abscissa and capacities in the ordinate. $L_M$ is calculated by using the battery as carefully as possible, and by memorising the points formed, over its lifetime, by its capacity value and the time of its measurement. $L_M$ ends at the point that indicates its **maximum life** ($t_M$, $C_m$) where the ordinate reaches the minimum operating capacity $C_m$. See **Figure 5.**

In the same way there is the $L_D$ curve, where the battery is treated abusively, producing a great premature **deterioration,** whose life extends to ($t_D$, $C_m$). Both curves start from the same point (**0, $C_N / C_n$),** as the batteries evaluated are identical. If the usual capacity measurement temperature is $T_n$, this point is (**0, $C_n$).**

Finally, the **W** battery, which is analysed, has generated an $L_W$ curve up to a point **P** ($t_P$, $C_R$), at which point it is interesting to know the **remaining life** $t_R$. The **tp** coordinate is the time elapsed from its entry into service until the **remaining life** $t_R$ is required.

It is accepted, for the time being, that the treatment that the battery will receive is similar to that received. From point **P** it is easy to interpolate between $L_M$ and $L_D$ to extrapolate the curve to $C_m$, and obtain on the one hand the real **expected life** $t_w$, with the particular treatment received, and thus we obtain the **remaining life** $t_R$ from point **P** which is: $t_R = t_w - t_P$.

If a change in treatment or living conditions is expected, interpolation allows this to be considered. In **Figure 5** it has been assumed that such expected treatment was similar to that already received. If this were not the case, the mathematics would draw a curve closer to $L_M$ or $L_D$.

## Information and equipment needed for analysis

It is necessary to have at least the equipment and data listed below.

**a)** The manufacturer provides information on the technology used in the manufacture of the **W** battery, its nominal capacity $C_N$ and its nominal voltage $V_N$ when new, curves, etc., and the **Standard** applied to define the battery, (DIN, JIS, SAE, etc.).

**b)** A temperature sensor is required to measure the temperature of the **W** battery at the time of analysis. This data allows us to know the capacity $C_n$ at that temperature $T_n$, when it was new, through of the corresponding curve.

**c)** There must be a discharger, with appropriate connections to the battery, which allows the choice of **IDs** that will be in the order of **0.1, 0.6, 1.0, 1.2, 1.4,** and **2 $C_n$ Amp.** or intermediate. A preferential **ID of 1.0 $C_n$ Amp.** is proposed. But any other can be used. Additionally it's necessary an ammeter and a voltmeter.

**d)** The family of discharge curves $G_{n,I}$, corresponding to the temperature $T_n$.

**e)** Logarithmic tables at the different temperatures of the range, which inform about the autonomy according to the discharge for each capacity, measuring the discharges in the abscissa and the autonomy in the ordinate, differentiating according to technologies and voltage. The final voltage $V_f$ of the battery must always be respected, following the **Standard.** An example is included in **Figure 4.**

**f)** To calculate the **autonomy,** it is necessary to know the **BEC.**

**g)** In the event that a charger is detected to be acting, it must be possible to disconnect it. Nor are variable charges or discharges allowed at any time during the analysis at a manual or laboratory level. Although in the **Industrial Application** if they can be considered, as well as to carry out iterations that allow a greater precision.

**h)** In order to calculate the **expected life,** tw and the **remaining $t_R$** at a given moment, it is necessary to have information on how the battery is going to be treated, and it is also convenient to have the $L_M$ and $L_D$ curves.

**Explanation of how the method works**

It is explained here how to obtain **ED** in a simple way, with the help of basic apparatus. The simplified flow diagram is followed according to **Figure 2.** Later, in the **Preferential Realization,** the way to automate all this is explained, so that it can be used simply by any user.

When the analysis is started, two situations can occur. That the battery is in perfect rest, or that it is supporting a discharge. The ammeter clarifies in which case we are in. It begins with a **W** battery in rest according with the following order;

**1)** The battery technology is known, and its $C_N$ capacity when new, its nominal voltage $V_N$, as well as the $G_{n,I1}$ curves for the chosen **ID, $I_1$.**

**2)** The sensor supplies the temperature of **W** which turns out to be $T_n$. The use of the corresponding curve allows us to know the capacity of the battery **W,** when **B** was new, at such a temperature, which turns out to be $C_n$.

**3)** The battery became connected, and the discharger sets the initial **ID** that results to be $I_1$, following the user's criteria and the recommendations given in the **Theoretical Base.** If there are reasons to believe that, given the conditions of the battery, it may have a capacity lower than $C_n$, the **ID** is suitably reduced. This intensity must be the same as that used to generate $G_{n,I}$.

**4)** The download begins. The discharge curve is observed for the necessary time, a few seconds, until it stabilizes and a stable voltage $V_v$ is obtained, and therefore the beginning of the discharge curve. If this curve is not clear, we will continue trying with some more time or with other discharges. Each discharge implies different $G_{n,I}$ curves.

**5)** As an example we propose $G_{n,1'0}$ , where we look, interpolating if necessary, for the curve produced by the discharge $I_1 = 1'0\ C_n$ Amp. to battery **W,** and which response with the voltage $V_v$. In this example it is the curve corresponding to **0.4 $C_n$ Ah.** See **Figure 1.** This discharge curve is equal to that produced by an **equivalent battery A,** new, charged, and with a capacity of **C = 0.4 $C_n$ Ah.**

**6)** It is concluded that the **ED** of the battery analysed **W,** has a behaviour analogous to that of an **equivalent battery A,** new, with a capacity **C = 0.4 $C_n$ Ah,** and fully charged. Now we know the required **ED,** which turns out to be that of battery **A.**

In the second case, there is consumption that is unwanted or unavoidable, which turns out to be a common situation. An **EV** is again given as an example. Some consumers cannot be inhibited, such as the clock, the on-board computer, etc., even though we can turn off for the calculation the most important ones, such as the engine, or the air conditioning. In this case, you must obtain instantaneous and perfectly simultaneous values for the ammeter, $I_2$, and the voltmeter, $V_2$. Then proceed as follows.

**1)** $I_2$, $V_2$ and battery temperature $T_n$ are available.

**2)** Also of the curves $G_{n,I2}$ corresponding to $I_2$ amperes and to the temperature $T_n$. The discharge $I_2$ generates a curve that starts with $V_2$ which gives an **equivalent battery $A_2$** with a $C_2$ capacity that when new and charged shall give same response.

**3)** If $I_2$ is too small, then the additional discharge of $I_1$ **Amp.** is added. Which is the same as if the battery were at rest, and the previous process is repeated taking into account that now the search is made for $G_{n,I3}$ since the **ID** is now;

$$I_3 = I_2 + I_1 \text{ Amp}.$$

If this method has been used previously, when the battery was no longer new, and its current **capacity** is known approximately, the latter is used as the starting point. Therefore, strictly speaking, only in the first calculation is $C_N$ used. In subsequent calculations, the last capacity found is used as the starting point. Therefore, the original capacity is never repeated in successive uses of the method. Except when it is used iteratively to refine the answer.

Once the **ED** has been calculated at the measurement temperature, as a utility or application, and known the **BEC**, the **autonomy** can be found. An example is given below.

Let it be a **W** battery, with its known **ED,** corresponding to an equivalent capacity of $C_1$. The **BEC** informs that two consecutive discharges $D_1$ and $D_2$ will be carried out separately. The first $D_1$, at current $I_1$ and at temperature $T_1$, has a duration of $t_1$. It is understood that this discharge does not exhaust the battery. Then, with the remaining energy, the second $D_2$ discharge is carried out, consisting of an **ID** of $I_2$, at a temperature $T_2$, and for the maximum time that this remaining energy allows. We are interested to calculate said **autonomy.**

The combination of the proposed downloads makes it possible to address all possible approaches to consumption. The percentage **p** of energy of **W** that $D_1$ consumes over the total available is then calculated.

    a) With the logarithmic table **Figure 4** corresponding to our parameters $T_1$, $I_1$, $C_1$, etc., you can find the **total autonomy** time $t_{M1}$ allowed by the battery.
    b) The ratio $t_1/t_{M1}$, is the approximate percentage of energy used by $D_1$ during $t_1$. In other words, **p.** The remaining energy is $C_1$ **(1 - p),** which corresponds to a new **battery equivalent to $C_2$,** which is then used.
    c) Again with the logarithmic table and the curves corresponding to $D_2$, $I_2$, $C_2$ and $T_2$, there is $t_{M2}$. This point informs about the **total** time of **autonomy** of **W** with the previous conditions.

Using time introduces a certain error since we do not know the average values of **V,** which are more laborious to find in the last section of the curve. A quicker calculation can be made assuming the average values of **V.** Although if we carry out a sensitivity analysis it is verified that errors of **2** or **3%** in its calculation, produce small variations in the value of energy. Finally, it would be more correct to obtain the equation of the discharge curve and make an integration, but it would add unnecessary accuracy and evident complexity. When the method is automated in the **Preferred Embodiment,** the calculation of the **ED** is instantaneous and exact.

Finally, two additional utilities or applications are presented here. When the battery being analysed is fully charged and at rest, the **ED** provides the **capacity.** And with the curve of its evolution in time, its **expected life tw** and the **remaining $t_R$,** provided that the subsequent treatment that the battery will receive is known.

## Brief Description of the Drawings

Five figures are included to help understand the method. They are particularizations, so they can be replaced by others even with variations, without losing validity or affecting the scope of what has been exposed.

    In **Figure 1,** it is showing an example of a family of discharge curves $G_{n,1'0Cn}$, of a new battery **B** with a capacity $C_n$, at temperature $T_n$, and using an **ID, I** = 1'0 $C_n$ Amp. The smaller batteries we choose have capacities of **0.3 $C_n$ Ah, 0.5 $C_n$ Ah** and **0.7 $C_n$ Ah.** If the same discharge **I** is now applied to the battery **W,** the voltage response $V_v$, begins to generate a curve which turns out to be **0.4 $C_n$ Ah.** which is the one corresponding to the **equivalent battery A.**

    In **Figure 2,** a simplified diagram is showing the flow of actions to find **ED** is represented, known as the data that define the **W** battery. This diagram is not complete for the sake of clarity. For example, the steps applied to $V_1$ asking about stability, cycle counter etc., have been saved in $V_2$ and $V_3$. Knowing $C_1$, $C_2$ or $C_3$ means knowing $A_1$, $A_2$ or $A_3$, and therefore **ED.**

    **Figure 3** represents a simplified diagram that follows the automated process of the method being patented applied to a device, that is the **Preferred Embodiment.**

    **Figure 4** shows an example of logarithmic tables at **25ºC** and voltage V that provide information on **autonomy,** depending on the **ID** and capacity of the **SLA-AGM** batteries. In this case we choose **0.3 $C_n$ Ah, 0.5 $C_n$ Ah, 0.7 $C_n$ Ah** and **$C_n$Ah.**

    In **Figure 5** the curves $L_M$, $L_D$, and $L_w$ are drawn, that allow to find the **expected life $t_w$** and the **remaining life $t_R$** of **W.**

## Preferred Embodiment

The purpose is to manufacture a device that automates the above method of finding the **ED** of a **W** battery. It can be portable or not, and with capacity adjustment on the characteristics of the different batteries to be analysed in certain voltage or capacity ranges. Or it can be adapted from the beginning to a particular battery.

A **System** is required that comprises an interface, an adapter, a discharger, a temperature sensor, a voltmeter, an ammeter, a chronometer, an **MCU** and the necessary software to record, store and analyse the curves produced by the discharger and compare them with those in memory by means of the algorithms provided, etc. This software will control the device, as well as communications with external equipment. It is enabled for the technology and **Standard** specified by the battery manufacturer and is greatly simplified if prepared for a specific battery. In this way its use includes the following steps:

A) The manufacturer first reports on the battery technology, as well as its $C_N$ capacity, nominal voltage $V_N$, curves, etc., when **B** was new.

B) All data are entered into the **System** via the interface. Once the **W** battery is connected, the analysis begins. There are batteries which, when connected, transmit all their characteristics to the **System**. However, this is not necessary when the application is made to a concrete battery, as is the case with an **EV** or a mobile phone.

C) The ammeter checks whether the battery is in standby. Initially, it is considered to be inactive.

D) The sensor supplies the temperature at which the battery is, $T_n$. With this temperature and the corresponding curve resident in the memory that relates the capacities and temperatures, the **System** determines the capacity $C_n$, which is the one corresponding to **B,** and which is the best approximation we have in the first analysis.

E) The **System,** following the instructions it has memorised, chooses the initial discharge intensity $I_1$. This discharge can feed a super capacitor and use the energy accumulated later.

F) Once the **System** obtains a stable response voltage $V_1$, it searches in $G_{n,I1}$, interpolating if necessary, the curve that starts with the voltage you have just measured. This curve is the same that produce the discharge of a **new equivalent battery $A_1$,** charged, and with a capacity of $C_1$.

G) With the known **ED,** the **System** can choose to display it in an interface, or supply it to another equipment that needs it, which is easily integrated into the device we already have.

Now suppose that the **System** ammeter detects that there is a continuous, and stable discharge. If the discharge does not have such conditions, instantaneous and simultaneous values must be measured. The ammeter provides to the **System** with the current consumption $I_2$, the voltmeter the voltage $V_2$, the sensor the **W** battery temperature $T_n$, and $C_n$ is calculated. The steps outlined are then followed.

1) Search in $G_{n,I2}$, obtained with $I_2$ amperes and at temperature $T_n$, the discharge curve corresponding to $V_2$. As before, it obtains the one corresponding to an **equivalent battery $A_2$,** with a new and charged $C_2$ capacity.

2) The **System** now adds an additional discharge $I_1$, calculated as before for the case where the battery was at rest, and repeats the previous process, taking into account that you must look for $G_{n,I3}$, as the discharge intensity is $I_3 = I_1 + I_2$. It obtains $C_3$. If you notice that $I_2$ is equal to or greater than $I_1$, you will reduce the first one by substracting what is appropriate. Even cancelling it, and taking for granted $C_2$.

In theory $C_3$ should be similar to $C_2$. However, since the battery is not at rest, nor balanced, the measurements may be altered. Probably the capacity found in last place $C_3$ is more accurate, but it is reasonable to calculate a weighting giving the weight to each one according to what the concrete application advises. Additional consecutive iterative measurements can also be made by changing the discharge etc. After this calculation, the **ED** is known, at the measurement temperature, that is the **equivalent battery $A_3$.**

As a utility or application, known the **BEC, autonomy** can be found easily and quickly, in the same way already explained. This speed allows that once the **BEC** has been applied, if the resulting autonomy is inadequate because it is insufficient, additional searches for new autonomies can be carried out. For which we could modify the **BEC,** eliminating or lowering the demands that can be reduced. Or accepting those that the device proposes.

Using an **EV** as an example, the cruise speed can be reduced. Or the device can propose a new one, or a combination of several depending on the profile of the road, and the temperatures expected on the different sections that will allow the required range. It is easy to incorporate it into autonomous driving.

Another application is to find the **capacity** of the battery. If, at the end of a charge, the **System** detects that the charger does not supply any current or is very small, it disconnects the charger and proceeds to calculate **ED**. In these conditions the **ED** found coincides with the **capacity** of the battery.

In the case of a **UPS** bench, it allows to know quickly the **ED**. As it is a device that is usually perfectly charged, disconnecting the charger and the charges for a few seconds (and even without disconnecting them if it is not possible), the **ED** is the same as the remaining capacity. A certain amount of rest would be desirable, but the distortion is always the same, and can be considered.

In another application, the **System** saves in the memory the capacities found over a period of time, generates a curve and extrapolates it, considering its database where $L_M$ and $L_D$ are, and knowing the predictable treatment, allows to obtain the **expected life $t_w$ and the remaining $t_R$.** In **Figure 5** we have considered that the treatment will be similar to the one previously received.

In addition to the advantages already mentioned, the rapid response of this device allows a more efficient use of battery power, as well as a more correct maintenance, and even to locate prematurely any anomaly. Or equalizing the cells of a pack in production. All this means optimising the performance and life of the battery with the corresponding cost savings.

In this case, the **Preferred Embodiment** coincides with the **Industrial Application.**

## Claims

1.  A **method** to calculate the energy available, **ED,** in an electric battery **W** at any moment in its life without discharging it, as well as its **autonomy, capacity** and **remaining life.** The following information and equipment at least is needed for this purpose.

    **a)** Knowledge of all the parameters and curves that define the used battery **W** when it was new **B,** as well as several new batteries of lower capacity, at the working temperature $T_n$, in order to calculate the $G_{n,I}$ curves .
    **b)** A discharger, voltmeter, ammeter, temperature sensor, and a charger that can be disconnected, with suitable connections.
    In the following, the invention is **characterized by** the understanding of the obtaining of the $G_{n,I}$ discharge curves. Given a new battery **B** with capacity $C_n$, voltage $V_N$ and temperature $T_n$, this is the name of a family of curves produced by the same **ID** fixed **I,** applied to **B** and to several new batteries of different lower capacities, all at the same temperature.
    In order to apply the method, the necessary connections are made, and there are **two** possible **situations** that the ammeter will detect:

    **I)** That the battery is at rest, isolated, without charge or discharge.
    **II)** That there is a discharge that cannot or is not desired to be avoided.

    **First case.** A discharge $I_1$ is carried out at **W** producing a response voltage $V_1$. Going to the family of curves $G_{n,I1}$, we find the **capacity $C_1$,** corresponding to an **equivalent battery A.** The **ED** of **A** is identical to the **ED** of **W.**
    **Second case.** If the existing **ID** is $I_2$ and the voltage $V_2$ is searched in $G_{n,I2}$, $C_2$ is obtained. Then, an additional discharge $I_1$, already calculated, is superimposed, leaving $I_3 = I_1 + I_2$, which produces a response voltage $V_3$, and with it the capacity $C_3$ is searched in $G_{n,I3}$, which, weighted with $C_2$, provides the **ED.**

2.  A **method** to calculate the available energy **ED** according to **claim 1, characterized by** understanding the obtaining of the discharge curves $G_{n,I}$ as follows. Given a new battery **B** with a capacity $C_n$, voltage $V_N$ and temperature $T_n$, we produce by the same **ID** fixed **I,** the discharge applied to **B** and to several new and charged batteries of different capacities below **B,** all at the same temperature.

3.  A **method** to calculate the energy available **ED** according to **claim 1, characterised by** obtaining **autonomy,** including knowledge of **ED** and the use of the **BEC,** static or dynamic.

4.  A **method** to calculate the available energy **ED** according to **claim 1, characterised by** obtaining the **capacity** of the battery **W.** For this purpose, a device comprising an ammeter and a charger is used. In the moment that is detected that the current provided to **W** when recharging is very small or null, the charger is disconnected and, at that moment, the **ED** calculated turns out to be the **capacity.**

5.  A **method** for calculating the available energy **ED** according to **claim 4, characterised by** finding the **remaining life $t_R$** of a battery **W,** at a given moment **P($t_P$, $C_R$),** which comprise knowing the expected treatment and interpolation between the $L_M$ and $L_D$ curves, until the ordinate reaches the operating capacity $C_m$, thus obtaining the expected life $t_w$. The operating time at the moment of calculation **tp** is subtracted from this value, which gives the remaining life $t_R$.

6.  A **system** that automates the **method** developed in the previous claims to calculate the available energy **ED** of any electric battery **W,** at any moment of its life, without discharging it, as well as its **autonomy, capacity** and **remaining life, characterized by** comprising interfaces, a discharger, thermal sensor, voltmeter, ammeter, chronometer, an **MCU** with the necessary software to record, memorize, and analyze the curves produced by the discharger and compare them with those in the memory provided by the manufacturer or previously calculated, as well as all the precise data, algorithms, and control communications with external equipment, etc.
    The **system** checks whether the **W** battery is in standby or not. If it is, it checks the temperature $T_n$, chooses the discharge, finds the equivalent battery **A** in $G_{n,I}$ and its **ED.** If the battery is not at rest, it will first find, always with the help of the $G_{n,I}$ curves, the **ED** corresponding to the discharge detected. In the following, another discharge intensity is superimposed, and with the sum of both, the **ED** is recalculated, with weighting between the two.

7.  A **system** that automates the **method** according to **claim 6, characterised by** finding the remaining **autonomy,** which comprise knowing **ED** and the **BEC.** The **BEC** can be dynamic and the temperature can change, which implies new values of **ED,** considering also the incorporation of data through the interface as well as through any telematic way.

8. A **system** that automates the **method** according to **claim 6, characterized by** obtaining the **capacity** of **W.** The **system** comprise a charger and an ammeter. At the end of the **W** recharge, when the ammeter detects that the current it receives is null or very small, the **System** software proceeds to disconnect the charger and find **ED,** a value that coincides with the **capacity** of **W** at that moment and at that temperature.

9. A **system** that automates the **method** according to **claim 8 characterised by** obtaining the remaining life $t_R$ of a **W** battery at any time $t_P$, for which the **System** generates the $L_w$ curve with the capacities as a function of time up to $t_P$. Knowing the expected treatment of **W,** the **System** interpolates $L_w$ between $L_M$ and $L_D$ and extrapolates to $y = C_m$, obtaining the expected life $t_w$, from which $t_P$ is subtracted to obtain $t_R$.

10. A **system** that automates the **method** according to **claim 6, characterised by** comprising a **software** that memorises and uses all the data provided by the manufacturer, comprising the specifications of the different batteries, discharge curves at different temperatures, the one that relates capacity and temperature, controlling all the hardware included in the **System,** which comprise reading, registering and using the databases provided, communicating with the interfaces, and with any equipment outside the **System,** including the dynamic data that informs it by any telematic means, etc.

**Figure 1**

**Figure 2**

**Figure 3**

**Figure 4**

**Figure 5**

## INTERNATIONAL SEARCH REPORT

| International application No. |
|---|
| PCT/ES2020/000058 |

### A. CLASSIFICATION OF SUBJECT MATTER

*G01R31/36* (2020.01)
*H01M10/48* (2006.01)
According to International Patent Classification (IPC) or to both national classification and IPC

### B. FIELDS SEARCHED

Minimum documentation searched (classification system followed by classification symbols)
G01R, H01M

Documentation searched other than minimum documentation to the extent that such documents are included in the fields searched

Electronic data base consulted during the international search (name of data base and, where practicable, search terms used)

EPODOC, INVENES

### C. DOCUMENTS CONSIDERED TO BE RELEVANT

| Category* | Citation of document, with indication, where appropriate, of the relevant passages | Relevant to claim No. |
|---|---|---|
| A | US 10302709 B2 (SHOA HASSANI LASHIDANI ET AL.) 28/05/2019, column 2, line 29 - column 3, line 12; column 5, line 30 - column 9, line 42; figures 1 - 6. | 1, 6 |
| A | US 2011004428 A1 (MUROCHI ET AL.) 06/01/2011, page 1, paragraph [9] - page 2, paragraph [11]; page 2, paragraph [31] - page 3, paragraph [45]; figures 1, 16, 17. | 1, 6 |
| A | CN 106646267 A (YUNNAN POWER GRID CO LTD ELECTRIC POWER RES INST; YUXI POWERSUPLLY BUREAU YUNNAN POWER GRID CO LTD; SHANGHAI WISCOM SUNEST ELECTRIC POWER TECH CO LTD.) 10/05/2017, Abstract from DataBase EPODOC. Retrieved from EPOQUE | 1, 6 |

☒ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 15/02/2021 | **(22/02/2021)** |

| Name and mailing address of the ISA/ | Authorized officer |
|---|---|
| OFICINA ESPAÑOLA DE PATENTES Y MARCAS Paseo de la Castellana, 75 - 28071 Madrid (España) Facsimile No.: 91 349 53 04 | R. San Vicente Domingo Telephone No. 91 3498525 |

Form PCT/ISA/210 (second sheet) (January 2015)

**INTERNATIONAL SEARCH REPORT**

| International application No. |
| --- |
| PCT/ES2020/000058 |

| C (continuation). | DOCUMENTS CONSIDERED TO BE RELEVANT | |
| --- | --- | --- |
| Category * | Citation of documents, with indication, where appropriate, of the relevant passages | Relevant to claim No. |
| A | WO 2019225032 A1 (THE FURUKAWA BATTERY CO LTD) 28/11/2019, Abstract from DataBase EPODOC. Retrieved from EPOQUE, Figures 1-3 | 1, 6 |

Form PCT/ISA/210 (continuation of second sheet) (January 2015)

17

## INTERNATIONAL SEARCH REPORT

Information on patent family members

International application No.

PCT/ES2020/000058

| Patent document cited in the search report | Publication date | Patent family member(s) | Publication date |
|---|---|---|---|
| US2018149708 A1 | 31.05.2018 | US10302709 B2 | 28.05.2019 |
| US2011004428 A1 | 06.01.2011 | JPWO2010001605 A1 | 15.12.2011 |
| | | RU2010132255 A | 10.08.2012 |
| | | CN102057289 A | 11.05.2011 |
| | | US8649988 B2 | 11.02.2014 |
| | | WO2010001605 A1 | 07.01.2010 |
| CN106646267 A | 10.05.2017 | NONE | |
| WO2019225032 A1 | 28.11.2019 | JP2019203719 A | 28.11.2018 |
| | | JP6430054B B1 | 28.11.2018 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10302709 B, Shoa Hassani Lashidani
- US 9692088 B, Koba
- US 7619417 B, Klang